Europäisches Patentamt

European Patent Office

Office européen des brevets

(11) Publication number: **0 044 496**

**A1**

(12) # EUROPEAN PATENT APPLICATION

(21) Application number: **81105455.0**

(22) Date of filing: **13.07.81**

(51) Int. Cl.³: **H 05 K 13/04**

(30) Priority: **22.07.80 IT 2359180**

(43) Date of publication of application:
**27.01.82 Bulletin 82/4**

(84) Designated Contracting States:
**AT CH DE FR GB LI NL SE**

(71) Applicant: **FERCO S.p.A.**
**Via della Pusteria, 29**
**I-20020 Misinto (Milan)(IT)**

(72) Inventor: **Ferri, Beniamino**
**Via Rovani 6**
**20052 Monza (Milan)(IT)**

(72) Inventor: **·Caimi, Giovanni**
**Via Volta 101**
**21047 Saronno (Varese)(IT)**

(74) Representative: **Borella, Ada**
**Ing. A. Racheli & C. Viale San Michele del Carso, 4**
**I-20144 Milan(IT)**

(54) **A process and apparatus for assembling electric microcomponents on printed circuits.**

(57) This invention provides a process and relating apparatus formed of set of gripping means (12) to withdraw and supply a plurality of microcomponents (11) to preselected positions of a board (20) for printed circuits. The process provides that each of the gripping means (12) are initially arranged at the top opening (15) of each microcomponent magazine; then a control member (13) provides to close said gripping means (12); a handling means moves said gripping means (12) from a position substantially corresponding to the free top opening (15) of the microcomponent magazine to another position substantially corresponding to the application position of said microcomponent (11) on said printed circuit board (20); and a means to feed said components along the magazine forming stacks, so as to allow the gradual withdrawn thereof.

FIG.8

Applicant:

FERCO S.p.A.

I - 20020 MISINTO (Milan)

Via della Pusteria, 29

"A PROCESS AND APPARATUS FOR ASSEMBLING ELECTRIC MICROCOMPONENTS
ON PRINTED CIRCUITS".

This invention relates to a process and apparatus to assemble electric microcomponents, for example the so-called chip type elements, which, as well known, are formed of nearly parallelcriped plates having the two minor bases thereof covered with a metal coating enabling the welding thereof on a printed circuit board. By suitable modifications to be made to the gripping means, it is however applicable to cylindrical microcomponents, such as MELF components, and active components provided with pins, such as SOT components.

As well known, these components are of extremely reduced size and accordingly are suitable to provide in a highly convenient way circuits of extremely reduced dimensions. However, this

- 2 -

inherent smallness thereof makes their handling extremely complicated and expensive. Thus, in the manufacture of even small series, such components would require an automatic assembling on the respective printed circuit boards.

Attempts have been already made to provide a machine to preset the desired microcomponents at the desired locations on a printed circuit board. According to this approach, the microcomponents contained in magazines as parallel stacks are vacuum withdrawn by a perforated flat withdrawing plate, the holes of which are connected to a vacuum source, said plate moving along a determined path, so as to deposit the withdrawn components on the printed circuit board as soon as the vacuum has been released. However, this process suffers from the disadvantage that at a single position of the withdrawing plate more than one microcomponent may often remain attached to said plate, thus providing faulty circuits.

It is another limitation of the apparatus at present used that the vacuum withdrawing plate directly contacts the printed circuit board, so as to preclude the use of partly occupied boards, comprising for example electric elements previously assembled thereon.

It is another disadvantage of the known approach that only microcomponents having the same thickness can be simultaneously applied, since these microcomponents should all come in contact with the printed circuit plate.

Therefore, it is the object of the present invention to provide a process and relating apparatus for assembling microcomponents on printed circuit boards, providing unexceptionable boards at reduced costs.

It is a further object of the invention to enable the use of printed circuit boards having a considerable overall size in thickness due to electric elements that have been previously assembled thereon.

It is still another object of the invention to enable the simultaneous assembling of microcomponents having different thicknesses.

Finally, it is another object of the present invention to allow, between the microcomponent gripping and supplying steps, the control of the provisions of the desired microcomponents and/or also an electric check thereof.

The above mentioned objects have been accomplished by providing the following operating cycle:

(a) at rest condition, the gripping means are arranged near the component located at the free top opening of the respective magazine;

(b) the gripping means close by gripping the microcomponent placed at the free top opening of each magazine;

(c) the gripping means are driven by the associated handling means, still holding therebetween the microcomponent previously gripped thereby, and approach it to the printed circuit board which had been previously provided with glue;

(d) the gripping means open, leaving the component on the printed circuit board;

(e) the gripping means move back to the originary position substantially near to the free top opening of each micro-components magazine; and

(f) the microcomponent stacks are fed by an amount corresponding to the thickness of the respective component in each stack.

An approach of the invention provides that during step (a) a visual and/or electric control can be made for the withdrawn microcomponents. In this latter case, the gripping means would be at least partially insulated.

A preferred embodiment of the invention provides that the microcomponent arranged immediately beneath the microcomponent located at the free top opening is retained by resilient means, which are hook-shaped, along with the remaining stack portion, thus positively causing the component gripped by the pliers to be separated from the underlying component, that is not allowing one microcomponent to adhere to another microcomponent when a microcomponent is gripped.

The relative apparatus for carrying out the above specified process comprises a series of means to simultaneously grip and supply a plurality of microcomponents at preselected positions of a printed circuit board on which such microcomponents are to be applied, each of such means being actuated by a control member capable of gripping and releasing the microcomponent arranged at the top opening of each stack making up a magazine; a handling means to move said gripping means from a position substantially corresponding to the free top opening of the micro-component stack to another position substantially corresponding to the application position for said microcomponent on said printed circuit board; and a means to feed said microcomponents along the magazine making up stacks, so as to enable the gradual withdrawal thereof.

An approach of the invention provides that each of the gripping means comprise a pliers having two sliding resilient legs and that the control member to open and close each gripping means comprises a resilient cam guide which, in turn, is actuated by a wedge-shaped plate, the displacement of which varies the position of said cam guide, within which the gripping means slide.

Preferably, resilieöt hook means are also provided, which hold the microcomponent arranged immediately beneath the component located at the free top opening of the microcomponent magazine, thus avoiding that the withdrawn microcomponent adheres to the adjacent microcomponent.

The invention will now be further explained with reference to an exemplary embodiment, which has been schematically shown in its successive operating steps on the accompanying drawings, in which:
Fig. 1 is an enlarged sectional view taken along line 1-1 of
Fig. 2, showing an apparatus according to the present invention, for the sake of simplicity comprising only a reduced number of microcomponent magazines;

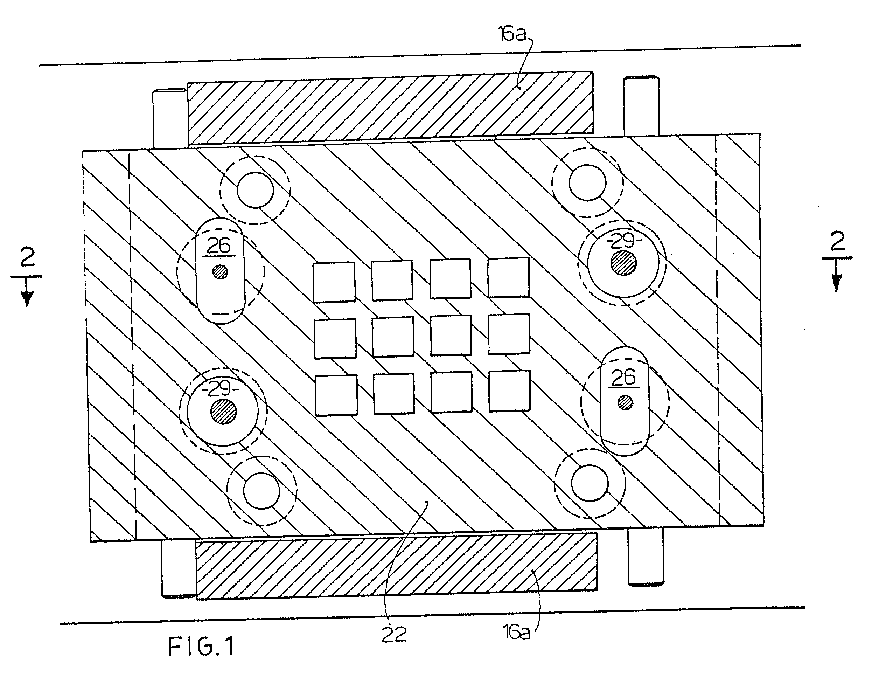

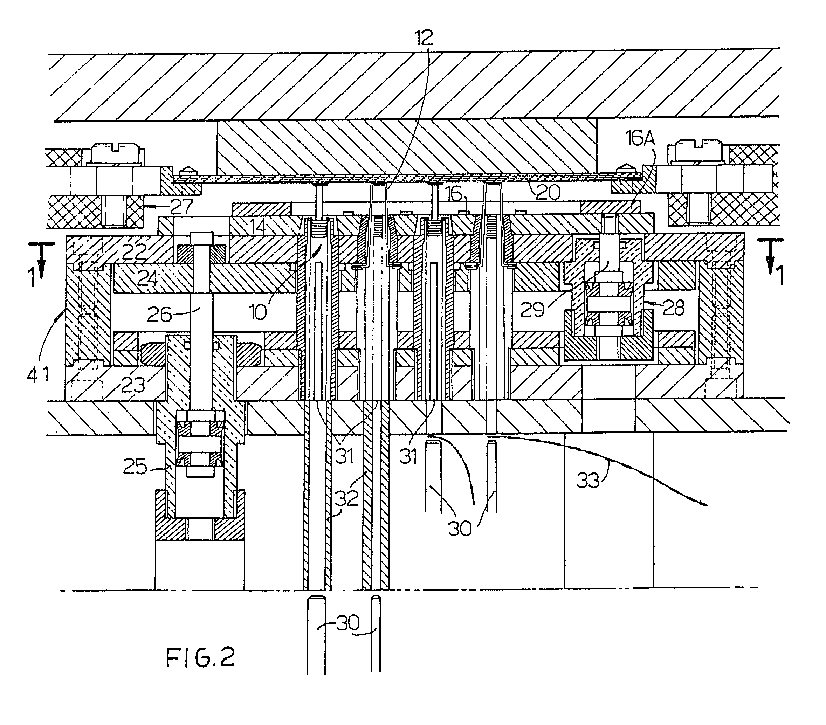

Fig. 2 is a sectional view taken along line 2-2 of Fig. 1;

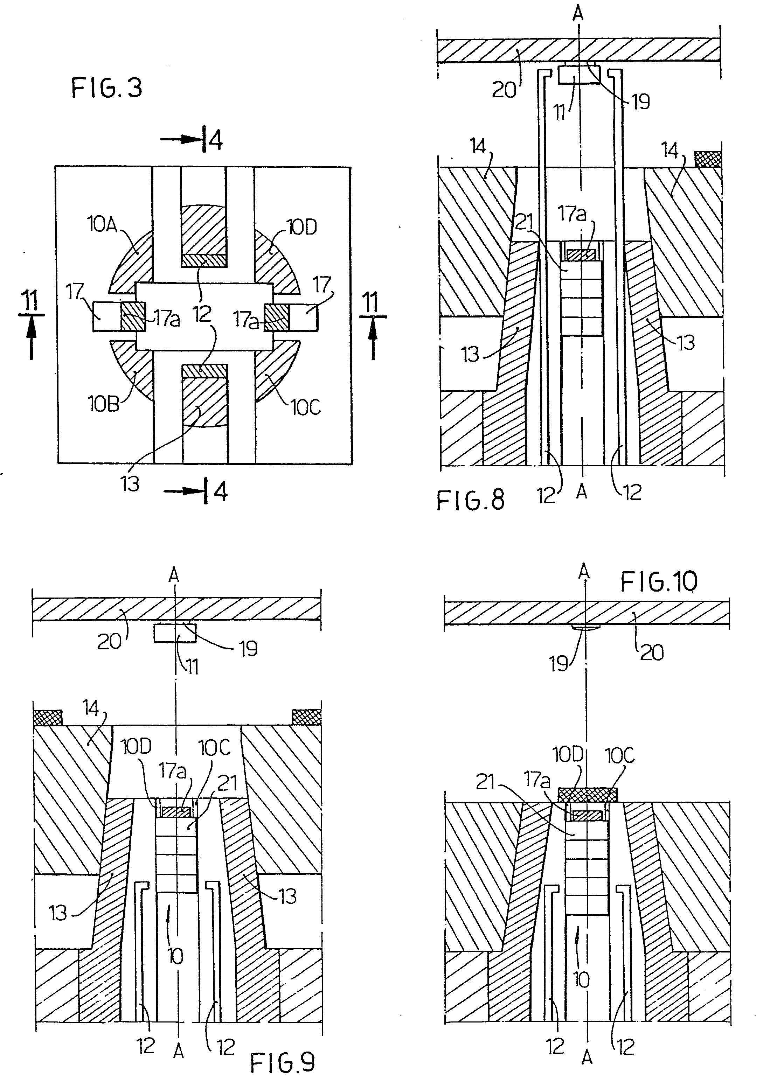

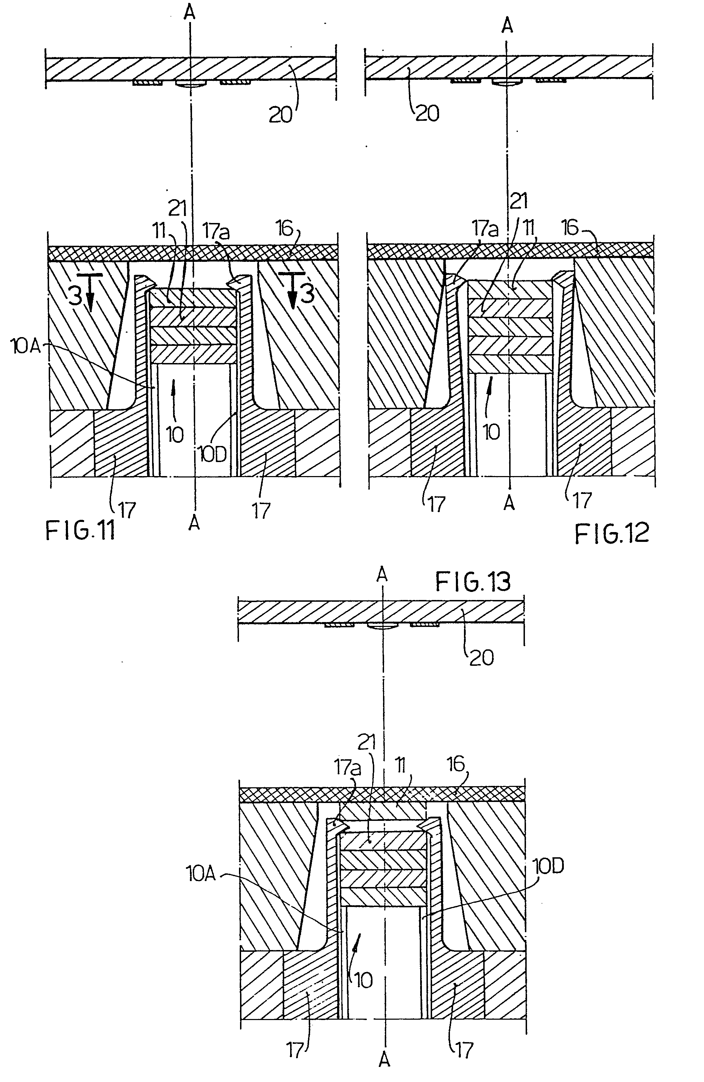

Fig. 3 is a further enlarged sectional view taken along line 3-3 of Fig. 11;

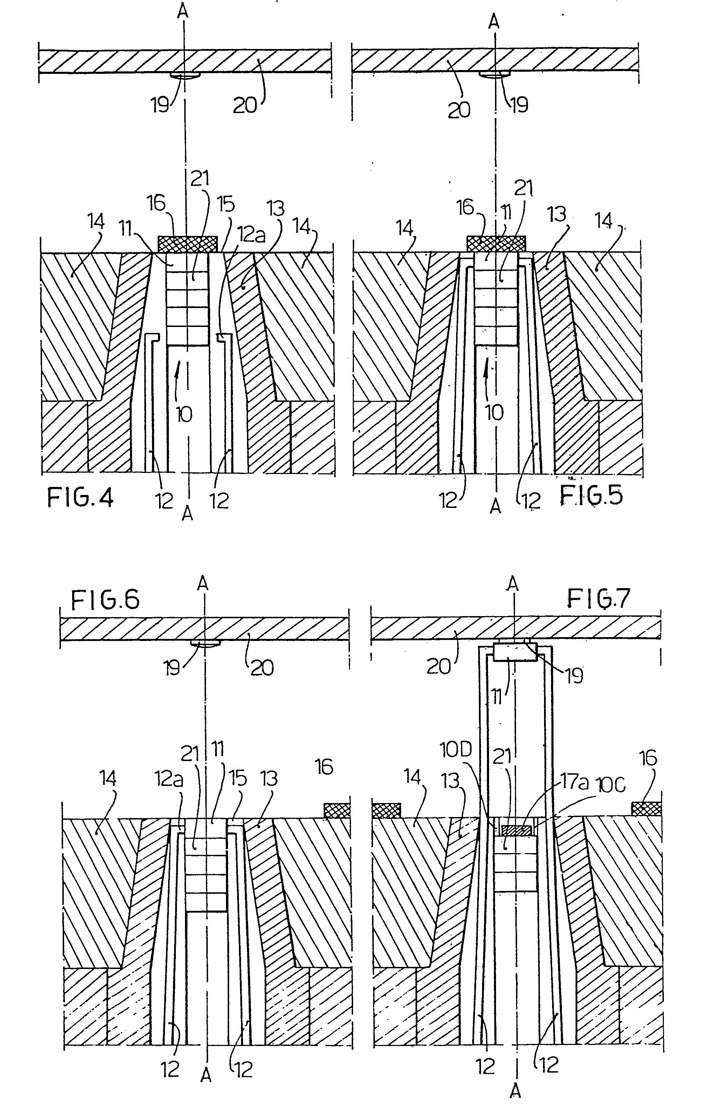

Figs. 4 through 10 are sectional views taken along line 4-4 of Fig. 3, showing the successive processing steps, the sizes of said views being still on enlarged scale, but different from those of the preceding views; and

Figs. 11, 12 and 13 are sectional views taken along line 11-11 of Fig. 3, also showing some operating steps, the views being on the same enlarged scale as those of Figs. 4 through 10.

It will be seen from Figs. 1 and 2 that the apparatus according to the invention comprises a series of magazines containing stacks 10 of microcomponents which are parallel to one another. In the example herein shown, the magazines are twelve, but actually the number will generally be of some thousands.

Said magazines are mounted within a fixed blocs 41 comprising two guide plates 22 and 23 and a plate 24 constituting the control plate for the pliers 12, said plate 24 being operated by a cylinder 25 having a stem 26 connected to plate 24.

The magazines are rectangularly shaped and, as shown in Fig. 2, a pair of them are rotated through 90° with respect to the other two magazines.

Short of the top opening 15 of said magazines 10 a printed circuit board 20 is placed and conventionally carried by moving means 27.

Each of the microcomponent magazines comprises four joined continuous walls which, adjacent to their top opening, are divided into four parts, each of which making up an angled

portion 10a, 10b, 10c and 10d (Fig. 3). Between one angled portion and the other, pliers 12 and resilient members 17 will penetrate. The pliers and resilient members may be differently shaped, and differently positioned, so that the electric microcomponents provided with pins at some parts thereof can be handled by the pliers in those parts where there are no pins. Thus, the microcomponent will not be damaged when being positioned on the plate.

Referring now to Figs. 4 through 10, the operation of the apparatus will be hereinafter explained. The component stack has reference numeral 10, the microcomponent arranged in proximity to the top opening of the magazine has reference numeral 11, the underlying magazine has reference numeral 21, while the gripping means has two legs of the pliers 12 having a gripping zone 12a. The two legs of pliers 12 vertically slide to-and-fro on the axis A-A of magazine 10 within a cam guide 13, which is driven by a plate 14 having wedge-shaped surfaces conjugated with the external surfaces of the cam guide 13, said plate 14 being also movable according to axis A-A direction.

The movement of plate 14 is caused, for example as shown in Figs. 1 and 2, by a pneumatic cylinder 28 having a stem 29 connected to said moving plate 14.

The microcomponent magazine opens toward the printed circuit board 20 with a top opening 15, which may be at least partially closed by a stop device 16, normally of grate-like configuration, as shown in Fig. 2, wherein the several stop devices 16 are secured to a support member 16A. Hereinafter the whole unit will be referred to as a stop grate.

The board 20, on which the printed circuit will be provided, will be previously locally covered by a drop of glue 19. Preferably, the glue will be applied by a plug and not necessarily by xerigraphy, so as to allow the use of printed circuits boards on which such electric members have been previously assembled as having some overall size extending also from the board part on which the microcomponents are to be assembled.

The gluing cycle for the printed circuit board, the board supply cycle to the component application position and the subsequent board withdrawal cycle, are carried out parallely with the movements relating to gripping and application of said microcomponents on said printed circuit boards.

The processing steps relating to gripping and supplying of said components will be as follows:

The microcomponent 11, which is immediately beneath the stop grate 16, is in the proximity of pliers 12, the latter being open. The cam guide 13, made of resilient material, is so arranged as to close as far as possible the top opening 15, through which the microcomponents can move out. This condition has been shown in Fig. 4.

The first movement being carried out is that shown in Fig. 5 when the pliers 12 raise upward and grip the microcomponent 11 by their ends 12a, said pliers 12 being guided by the cam guide 13 which is at retracted position.

The next movement is given by said stop grate 16 which laterally moves positioning itself between one top opening 15 and the other so that the microcomponent 11 is enable to exit therefrom; said position has been shown in Fig. 6.

Since the top opening 15 for the first microcomponent 11 is free the pliers holding said microcomponent can be caused to exit, so as to reach the board 20 and then applying said microcomponent 11 on the glue drop 19. This step has been shown in Fig. 7.

Prior to said pliers 12 contact the board 20, a visual and/or electric control can be effected for the just withdrawn microcomponent 11. For the electric control, partially insflated pliers 12 will be provided.

Once the microcomponent has been applied on board 20, the pliers are allowed to spread out. This occurs as soon as said wedge--shaped plate 14 is raised, causing said cam guide 13 to move back to its open position, as shown in Fig. 8.

Then pliers 12 are caused to re-enter within the cam guide 13. This can be readily done, see Fig. 9, since said cam guide 13 is now at open position.

As a next step, it is provided that the control plate 14 for the cam guide 13 is lowered again, thus closing said cam guide 13 (Fig. 10); at the same time the stop grate 16 moves to close the free top opening 15 of the components.

It should be pointed out that some steps of the above described process could be simultaneously or almost simultaneously carried out. Particularly, the step at which the microcomponent 11 is gripped by pliers 12 could be simultaneous with the displacement step of the stop grate, so as to clear the top opening 15. Also the return step of the pliers 12 to the gripping zone could be simultaneous with the closing step of the top opening 15.

In Figs. 11, 12 and 13 a secjional view is shown as taken perpendicularly to the sectional view shown in Figs. 4 through 10. The microcomponents in the respective magazines are here shown as arranged at 90° with respect to the position shown in Figs. 4 through 10. In these figures, there are shown resilient members 17 providing hooking means 17a at the ends thereof, which can hold the microcomponent 21 arranged immediately beneath the end microcomponent which is driven by the gripping means. When these resilient members 17 are pushed thanks to the action exerted to the supply end 31 of the microcomponent magazine 10, such members open, as shown in Fig. 12, so that a microcomponent designated by reference numeral 11 is enable to exit. This forward movement of the microcomponents within the relative magazine is accomplished when the stop grate 16 is again arranged over the top opening 15. From Fig. 13, which is just a sectional view at 90° of Fig. 4, it clearly appear that microcomponent withdrawal occurs while the adjacent component 21 is firmly grosped by the resilient members 17, so that any possible sticking thereof is avoided.

The feeding movement of the components in the relative magazines can be given by movable push rods 30 reciprocating through a differentiated adjustable stroke, so as to take into account the different thicknesses of the components. Since the stop grate 16 is provided at such a position as to close the top opening 15, each of the components will be surely pushed to the
correct position, so as to contact  said stop grate 16. The
push rods 30 may be introduced into the lower end of furhter
magazines 32 arranged on the extension of the magazines from
which the withdrawal is carried out. In this way it is possible
to feed to the supply end 31 of magazines 10 a new microcomponents
carried on a tape 33. This has been shown at the right side of
Fig. 2, whereas the approach formerly described has been shown
at the left side of the same figure. Of course, the components
could be also supplied by a positioner feeder. The microcomponents
feeding takes  place on passing from the step shown in Fig. 10
to  the step shown in Fig. 4.

This invention embraces all of those detail modifications which
may be obvious to those skilled in the art.

FERCO S.p.A.


C L A I M S


1.      A process for applying microcomponents on printed circuit boards, according to which said microcomponents are withdrawn from a series of magazines arranged in side by side and in parallel relationship to one another and caused to adhere to a printed circuit board previously provided with glue, characterized in that:

(a) the gripping means (12) arranged adjacent the top opening (15) of the magazines are at open position;

(b) each of the gripping means (12) close by gripping the microcomponent (11) arranged immediately close to the top opening (15) of the relative magazine (10);

(c) the gripping means (12) are driven by handling means, while holding therebetween the microcomponent (11) previously gripped thereby and carry it to the printed circuit board (20) which, as known, had been previously provided with glue (19);

(d) the gripping means (12) open, leaving the microcomponent (11) on the printed circuit board;

(e) the gripping means move back to the originary position thereof substantially adjacent the top opening (15) of the microcomponent magazines; and

(f) the microcomponent stacks are fed by an amount corresponding to the thickness of the relative microcomponent.


2.      A process according to Claim 1, characterized in that the gripping means (12) grip the microcomponents on two parallel opposite sides and that the microcomponent stacks is retained, in a perpendicular direction to that where the gripping means are provided, by resilient means (17) provided with hooks (17a) which hold the microcomponent (21) coming in contact therewith, which is arranged adjacent to the microcomponent (11) which is withdrawn and moved away by the pliers (12).

3. A process according to Claim 1 or Claim 2, characterized in that the step of gripping the microcomponent (11) is simultaneously carried out with the step of moving the stop device (16) away from the top opening (15).

4. A process according to any of the preceding Claims 1, 2 and 3, characterized in that the step during which the gripping means (12) move back to the originary position is simultaneous with the step during which the free top opening (15) are closed by stop devices (16).

5. A process according to any of Claims 1-4, characterized in that during the component handling step a visual and/or electric control is provided for the microcomponent (11) just withdrawn.

6. An apparatus for carrying out the process according to Claims 1-5 comprising a series of means for gripping a set of microcomponents arranged at the end of parallel magazine forming stacks and supplying the same to predetermined positions of a printed circuit board, characterized in that a gripping means (12) is provided to withdraw the microcomponent (11) arranged at the top opening (15) of each magazine forming stacks (10); a handling means (24) is provided to move said gripping means (12) from a position substantially corresponding to the free top opening (15) of a magazine to a position corresponding to the application position of said microcomponent on said printed circuit board (20); and means (30) are provided to feed said components by an amount corresponding to the thickness of said microcomponents within the magazines, so as to enable the successive withdrawal of the microcomponents.

7.      An apparatus according to Claim 6, characterized in that resilient hook means (17) are also provided and hold the microcomponent (21) immediately beneath the microcomponent (11) located at the top opening (15) of each magazine (10), which microcomponent is withdrawn and moved away by the gripping means (12).

8.      An apparatus according to Claim 6 or Claim 7, characterized in that the control member to open and close each of the gripping means (12) comprises a resilient cam guide (13) having each of the gripping means (12) sliding therein, which guide (13) is operated in turn by a wedge-shaped plate (14), the movement of which varies the position of said cam guide (13), within which the gripping means (12) slide.

9.      An apparatus according to any of Claims 6 to 8, characterized in that each of the gripping means comprise two resilient pliers legs gripping two parallel opposite sides of the microcomponent (11).

- 15 -

10.     An apparatus according to any of Claims 6 to 9, <u>characterized in that</u> the gripping means are at least partially insulated.

FIG.1

FIG.2

FIG.3

FIG.8

FIG.9

FIG.10

0044496

FIG.4

FIG.5

FIG.6

FIG.7

0044496

5/5

FIG.11

FIG.12

FIG.13

European Patent
Office

**EUROPEAN SEARCH REPORT**

| | DOCUMENTS CONSIDERED TO BE RELEVANT | | | CLASSIFICATION OF THE APPLICATION (Int. Cl.³) |
|---|---|---|---|---|
| Category | Citation of document with indication, where appropriate, of relevant passages | Relevant to claim | | |
| A | DE - A - 2 716 330 (MATSUSHITA ELECTRIC INDUSTRIAL CO.)<br><br>* claims; figures 1-14 *<br><br>--------- | 1,2,6 | | H 05 K 13/04 |

| | TECHNICAL FIELDS SEARCHED (Int. Cl.³) |
|---|---|
| | H 05 K 13/04<br>13/02<br>3/30<br>H 01 L 21/66 |

CATEGORY OF
CITED DOCUMENTS

X  particularly relevant

A. technological background

O. non-written disclosure

P  intermediate document

T  theory or principle underlying
   the invention

E  conflicting application

D  document cited in the
   application

L· citation for other reasons

&  member of the same patent
   family,
   corresponding document

The present search report has been drawn up for all claims

| Place of search Hague | Date of completion of the search 02-10-1981 | Examiner VAN REETH |
|---|---|---|

EPO Form 1503.1  06.78